# EUROPEAN PATENT SPECIFICATION

(11) **EP 4 471 444 B1**
(45) Date of publication and mention of the grant of the patent: **24.06.2026**
(21) Application number: 23868629.9
(22) Date of filing: 21.09.2023
(51) Int. Cl.: G01R 31/396, G01R 31/392, G01R 31/3842, G01R 31/367

(54) **APPARATUS AND METHOD FOR DIAGNOSING BATTERY**
VORRICHTUNG UND VERFAHREN ZUR BATTERIEDIAGNOSE
DISPOSITIF ET PROCÉDÉ POUR LE DIAGNOSTIC DE BATTERIE

(30) Priority: 22.09.2022 KR 20220119803
(43) Date of publication of application: 04.12.2024
(73) Proprietor: LG Energy Solution, Ltd., Seoul 07335 (KR)
(72) Inventor: CHA, A-Ming, Daejeon 34122 (KR); BAE, Yoon-Jung, Daejeon 34122 (KR)
(74) Representative: Goddar, Heinz J.
(86) International application number: PCT/KR2023/014442
(87) International publication number: WO 2024/063577

(56) References cited:
- CN-A- 102 393 509
- CN-A- 111 308 379
- CN-B- 111 308 379
- KR-A- 20180 005 345
- KR-A- 20210 150 217
- US-A1- 2022 252 670
- US-A1- 2022 252 670

## Description

### TECHNICAL FIELD

The present application claims priority to Korean Patent Application No. 10-2022-0119803 filed on September 22, 2022 in the Republic of Korea.

The present disclosure relates to an apparatus and method for diagnosing a battery, and more particularly, to an apparatus and method for diagnosing a battery, which is capable of diagnosing a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being done on the batteries in terms of increasing capacity and density, improvements in lifespan and safety are also important. In order to improve battery safety, technology to accurately diagnose the current state of the battery is required.

For example, it is necessary to prevent lithium precipitation on the surface of the negative electrode (lithium plating, Li-plating). When lithium is precipitated on the surface of the negative electrode, it causes side reactions with the electrolyte and changes in the kinetic balance or the like of the battery, causing battery deterioration. In addition, as lithium metal is precipitated on the surface of the negative electrode, an internal short circuit of the battery may occur, and thus there is a risk of ignition or explosion due to an internal short circuit. Therefore, there is a need to develop technology that can detect whether lithium metal is precipitated on the surface of the negative electrode.

US 2022/252670 A1 describes that a used battery is partially charged over a small voltage range using a Constant Current (CC) until a voltage target is reached, and the current integrated to obtain the CC charge applied, Qcc. Then the battery continues to be charged using a Constant Voltage (CV) of the voltage target until the charging current falls to a midrange current target before the battery is fully charged. The current is integrated over the CV period to obtain the CV charge applied, Qcv. The measured SCCIR is the ratio of Qcc to (Qcc+Qcv) and is input to a calibration curve function to obtain a modeled State of Health (SOH) value for sorting. The calibration curve function is obtained by aging new batteries to obtain SCCIR and SOH data that are modeled using a neural network.

CN 111 308 379 B describes a battery health state estimation method based on local constant-voltage charging data, and the method comprises the following steps: S1, carrying out cyclic charging and discharging experiment of a battery under different temperature and charging multiplying power conditions, and measuring the current and terminal voltage of the battery in real time; S2, under the conditions of different temperatures and CC (constant current) charging rates, fitting a linear relationship between CV (constant voltage) charging capacity and CCCV (constant current first and then constant voltage) charging capacity, and establishing a parameter mapping database of a linear model; S3, establishing a CV stage charging current prediction model, identifying model parameters by using the local CV charging data, and predicting the whole CV charging data; and S4, selecting a corresponding linear model from the parameter mapping database according to the temperature of the actual charging process and the CC charging rate, and calculating the SOH (state of health) of the battery according to the estimated CV charging capacity.

### DISCLOSURE

### Technical Problem

The present disclosure is designed to solve the problems of the related art, and therefore the present disclosure is directed to providing an apparatus and method for diagnosing a battery, which is capable of quickly diagnosing a current state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims.

### Technical Solution

An apparatus for diagnosing a battery according to one aspect of the present disclosure may comprise a profile obtaining unit configured to obtain a capacity profile for a constant current charging capacity and a constant voltage charging capacity measured in a charging process of a battery; and a control unit configured to calculate a capacity change rate between the constant current charging capacity and the constant voltage capacity charging in the capacity profile, compare the calculated capacity change rate with a preset reference value, and diagnose the state of the battery based on the comparison result.

The control unit is configured to diagnose the state of the battery as an available lithium loss state, a normal state, or a positive electrode capacity deterioration state based on the comparison result.

The control unit may be configured to diagnose the state of the battery as the available lithium loss state, when the capacity change rate is less than the reference value.

The control unit may be configured to diagnose the state of the battery as the normal state, when the capacity change rate is identical to the reference value.

The control unit may be configured to diagnose the state of the battery as the positive electrode capacity deterioration state, when the capacity change rate exceeds the reference value.

The control unit may be configured to classify the capacity profile into at least one capacity section according to the magnitude relationship between the capacity change rate and the reference value, and diagnose the state of the battery for the classified capacity section.

The control unit may be configured to calculate the capacity change rate for each of a plurality of constant current charging capacities included in the capacity profile, determine a target capacity whose corresponding capacity change rate is equal to the reference value among the plurality of constant current charging capacities, and classify the capacity section based on the determined target capacity.

The control unit may be configured to diagnose the state of the battery as an unusable state, when the state of the battery is sequentially diagnosed as the positive electrode capacity deterioration state, the available lithium loss state, and the positive electrode capacity deterioration state.

The control unit may be configured to change a use condition preset for the battery to correspond to the state of the battery.

The control unit may be configured to change at least one of an upper limit of a charging C-rate preset for the battery and a rest period, when the state of the battery is diagnosed as the available lithium loss state.

The control unit may be configured to change at least one of an upper limit voltage and a maximum allowable temperature preset for the battery, when the state of the battery is diagnosed as the positive electrode capacity deterioration state.

The capacity profile may be a profile configured to accumulate and store the corresponding relationship between the constant current charging capacity and the constant voltage charging capacity measured at each charging cycle for the battery.

A battery pack according to another aspect of the present disclosure may comprise the apparatus for diagnosing a battery according to one aspect of the present disclosure.

An electric vehicle according to still another aspect of the present disclosure may comprise the apparatus for diagnosing a battery according to one aspect of the present disclosure.

An energy storage system according to still another aspect of the present disclosure may comprise the apparatus for diagnosing a battery according to one aspect of the present disclosure.

A method for diagnosing a battery according to still another aspect of the present disclosure may comprise a capacity profile obtaining step of obtaining a capacity profile for a constant current charging capacity and a constant voltage charging capacity measured in a charging process of a battery; a capacity change rate calculating step of calculating a capacity change rate between the constant current charging capacity and the constant voltage capacity charging in the capacity profile; a comparing step of comparing the calculated capacity change rate with a preset reference value; and a state diagnosing step of diagnosing the state of the battery as an available lithium loss state, a normal state, or a positive electrode capacity deterioration state based on the comparison result.

### Advantageous Effects

According to one aspect of the present disclosure, the apparatus for diagnosing a battery is characterized by being able to quickly and specifically diagnose the state of a battery according to the degree of change between a constant current charging capacity and a constant voltage charging capacity.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a first capacity profile according to an embodiment of the present disclosure.
FIG. 3 is a diagram comparing a first capacity curve of the first capacity profile and a reference line according to an embodiment of the present disclosure.
FIG. 4 is a diagram to explain a positive electrode capacity deterioration state of a battery according to an embodiment of the present disclosure.
FIG. 5 is a diagram to explain an available lithium loss state of the battery according to an embodiment of the present disclosure.
FIG. 6 is a diagram schematically showing a second capacity profile according to an embodiment of the present disclosure.
FIG. 7 is a diagram comparing a second capacity curve of the second capacity profile and the reference line according to an embodiment of the present disclosure.
FIG. 8 is a diagram schematically showing an exemplary configuration of a battery pack according to another embodiment of the present disclosure.
FIG. 9 is a diagram schematically showing an electric vehicle according to still another embodiment of the present disclosure.
FIG. 10 is a diagram schematically showing an ESS according to still another embodiment of the present disclosure.
FIG. 11 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure.

Therefore, the description proposed herein is just a preferable example for the purpose of illustrations only, not intended to limit the scope of the present invention, which is defined by the appended claims.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

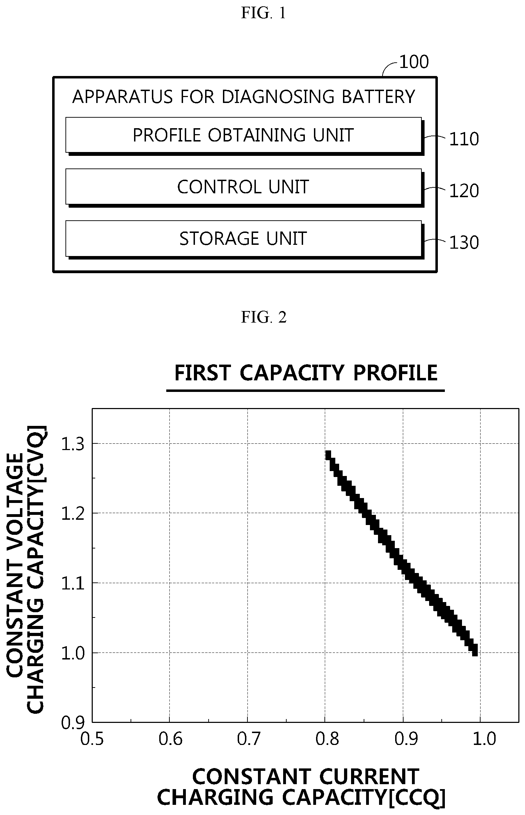

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110, a control unit 120, and a storage unit 130.

Here, the battery refers to an independent cell that has a negative electrode terminal and a positive electrode terminal and is physically separable. As an example, a lithium-ion battery or a lithium polymer battery may be considered a battery. Additionally, the battery may mean a battery module in which a plurality of cells are connected in series and/or parallel. Below, for convenience of explanation, the battery is explained as meaning one independent cell.

The profile obtaining unit 110 may be configured to obtain a capacity profile for a constant current charging capacity and a constant voltage charging capacity measured in the charging process of the battery.

For example, the profile obtaining unit 110 may receive a capacity profile from the outside using a provided communication module.

As another example, the profile obtaining unit 110 may be connected to the storage unit 130 to perform wired communication and/or wireless communication. The profile obtaining unit 110 may access the storage unit 130 to obtain the capacity profile stored in the storage unit 130.

Specifically, the capacity profile may be a profile configured to accumulate and store the corresponding relationship between the constant current charging capacity and the constant voltage charging capacity measured at each charging cycle for the battery. Here, the constant current charging capacity refers to a charging capacity when the battery is charged with a constant current (CC). Also, the constant voltage charging capacity refers to a charging capacity when the battery is charged with a constant voltage (CV).

Generally, when explaining the charging process of a battery, the battery is charged with a constant current until the voltage reaches a preset cut-off voltage. In the constant current charging process, the charging current is kept constant, and the voltage of the battery rises in proportion to the current. Also, when the voltage of the battery reaches the cut-off voltage, the battery is charged with a constant voltage. In the constant voltage charging process, the battery voltage is kept constant, and the charging current is gradually reduced. Also, when the charging current reaches the preset cut-off current, battery charging ends.

For example, when a total of 100 charging cycles are performed, the capacity profile may include the corresponding relationship between the constant current charging capacity and the constant voltage charging capacity for 100 cycles.

FIG. 2 is a diagram schematically showing a first capacity profile P1 according to an embodiment of the present disclosure.

Specifically, the first capacity profile P1 is a profile that represents the corresponding relationship between the constant current charging capacity and the constant voltage charging capacity of the first battery. The first capacity profile P1 is a normalized profile based on the first constant current charging capacity and the first constant voltage charging capacity. The normalized constant current charging capacity of the battery at the present may be 0.8, and the normalized constant voltage charging capacity may be about 1.28.

The control unit 120 may be configured to calculate the capacity change rate between the constant current charging capacity and the constant voltage charging capacity in the capacity profile.

Specifically, the control unit 120 may calculate the change rate of the constant voltage charging capacity with respect to the constant current charging capacity as a capacity change rate.

For example, the capacity change rate may be an instantaneous change rate or an average change rate of the constant voltage charging capacity with respect to the constant current charging capacity.

In one embodiment, the control unit 120 may calculate an instantaneous change rate between the constant current charging capacity and the constant voltage charging capacity most recently included in the capacity profile. Specifically, the control unit 120 may obtain a capacity curve corresponding to the capacity profile through curve fitting. Also, the control unit 120 may calculate the instantaneous change rate at the desired constant current charging capacity based on the relationship equation of the capacity curve.

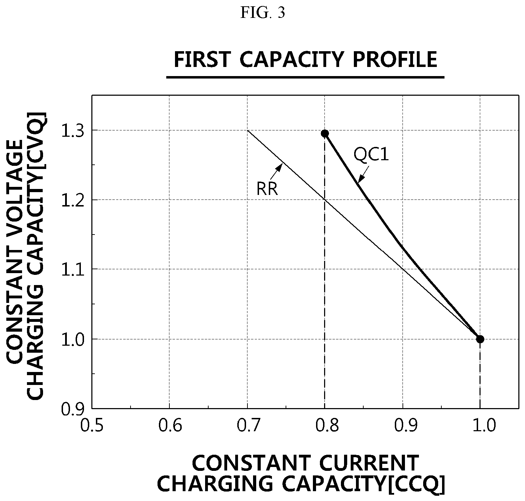

FIG. 3 is a diagram comparing a first capacity curve QC1 of the first capacity profile P1 and a reference line RR according to an embodiment of the present disclosure.

In the embodiment of FIG. 3, the first capacity curve QC1 may be a capacity curve obtained from the first capacity profile P1 using a curve fitting algorithm. The first capacity curve QC1 may represent the corresponding relationship between the constant current charging capacity and the constant voltage charging capacity in the constant current charging capacity section of 0.8 to 1.0.

The control unit 120 may be configured to compare the calculated capacity change rate and a preset reference value.

Preferably, the control unit 120 may compare an absolute value of the calculated capacity change rate and the preset reference value. That is, the capacity change rate calculated by the control unit 120 may be 0 or a positive real value. Hereinafter, for convenience of explanation, note that the comparison between the capacity change rate and the reference value means comparing the absolute value of the capacity change rate and the reference value.

In the embodiment of FIG. 3, it is assumed that the reference line RR is a straight line in which the absolute value of the slope is set as the reference value. For example, the reference value may be preset to 1. Also, the reference line RR may be a straight line with a slope of -1. That is, the absolute value of the slope of the reference line RR and the reference value may be 1.

Specifically, the control unit 120 may compare the magnitude between the calculated capacity change rate and the reference value.

For example, in the embodiment of FIG. 3, the average change rate and the instantaneous change rate of the first capacity curve QC1 may be smaller than the slope of the reference line RR. Therefore, the control unit 120 may determine that the reference value is smaller than the capacity change rate (specifically, the absolute value of the capacity change rate) of the first capacity curve QC1.

The control unit 120 may be configured to diagnose the state of the battery based on the comparison result.

Specifically, the control unit 120 may be configured to diagnose the state of the battery as an available lithium loss state, a normal state, or a positive electrode capacity deterioration state based on the comparison result. That is, the control unit 120 may diagnose the state of the battery as an available lithium loss state, a normal state, or a positive electrode capacity deterioration state based on the magnitude comparison between the reference value and the capacity change rate.

For example, if the capacity change rate is less than the reference value, the control unit 120 may diagnose the state of the battery as an available lithium loss state. As another example, if the capacity change rate is equal to the reference value, the control unit 120 may diagnose the state of the battery as a normal state. As still another example, if the capacity change rate exceeds the reference value, the control unit 120 may diagnose the state of the battery as a positive electrode capacity deterioration state.

For example, in the embodiment of FIG. 3, because the capacity change rate of the first capacity profile P1 exceeds the reference value, the control unit 120 may diagnose the state of the first battery as a positive electrode capacity deterioration state.

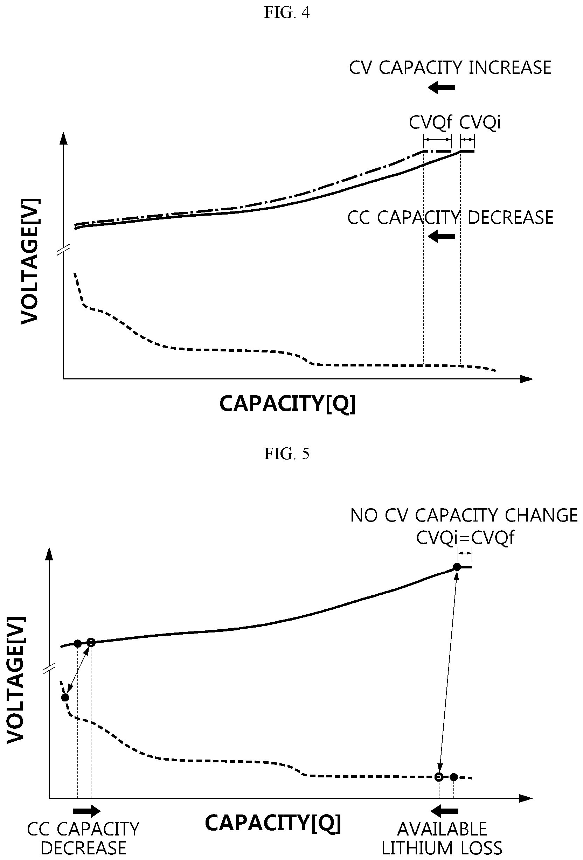

FIG. 4 is a diagram to explain a positive electrode capacity deterioration state of a battery according to an embodiment of the present disclosure.

Referring to FIG. 4, when the positive electrode capacity of the battery is deteriorated, the constant voltage charging capacity (CV capacity) may increase from CVQi to CVQf. Also, the constant current charging capacity (CC capacity) may be reduced. In other words, as the positive electrode capacity is deteriorated, the change rate of the constant voltage charging capacity with respect to the constant current charging capacity may change rapidly. Therefore, if the capacity change rate of the capacity profile exceeds the reference value, the control unit 120 may diagnose the state of the battery as a positive electrode capacity deterioration state.

FIG. 5 is a diagram to explain an available lithium loss state of the battery according to an embodiment of the present disclosure.

Referring to FIG. 5, when the available lithium of the battery is lost, the constant voltage charging capacity (CV capacity) may not change. Also, the constant current charging capacity (CC capacity) may be reduced by the loss of available lithium. **In** other words, as available lithium is lost, the change rate of the constant voltage charging capacity to the constant current charging capacity may change gradually. Therefore, if the capacity change rate of the capacity profile is less than the reference value, the control unit 120 may diagnose the state of the battery as an available lithium loss state.

The apparatus 100 for diagnosing a battery according to an embodiment of the present disclosure is characterized by being able to quickly and specifically diagnose the state of the battery depending on the degree of change between the constant current charging capacity and the constant voltage charging capacity.

The apparatus 100 for diagnosing a battery may diagnose the state of the battery by considering only the corresponding relationship between the constant current charging capacity and the constant voltage charging capacity without being affected by the charging C-rate (Current rate). Therefore, in situations where there are no restrictions such as low-rate charging (e.g., 0.05 C charging) or data comparison at the same C-rate, the apparatus 100 for diagnosing a battery may quickly diagnose the state of the battery.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

The control unit 120 may be configured to classify the capacity profile into at least one capacity section according to the magnitude relationship between the capacity change rate and the reference value.

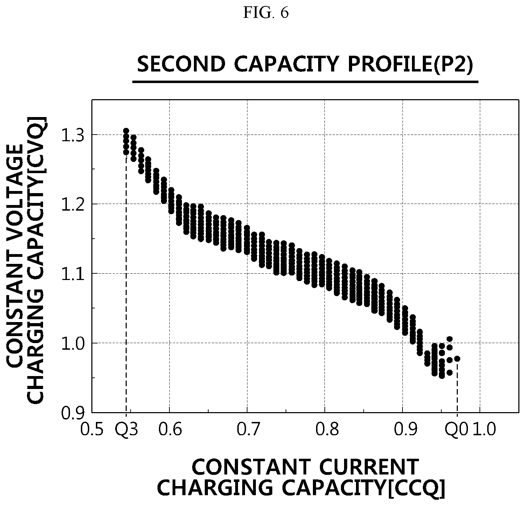

FIG. 6 is a diagram schematically showing a second capacity profile P2 according to an embodiment of the present disclosure.

Specifically, the second capacity profile P2 is a profile that represents the corresponding relationship between the constant current charging capacity and the constant voltage charging capacity of the second battery. The second capacity profile P2 is a profile normalized based on the first constant current charging capacity and the first constant voltage charging capacity. The normalized constant current charging capacity of the battery at the present may be Q0, and the normalized constant voltage charging capacity may be about 1.3.

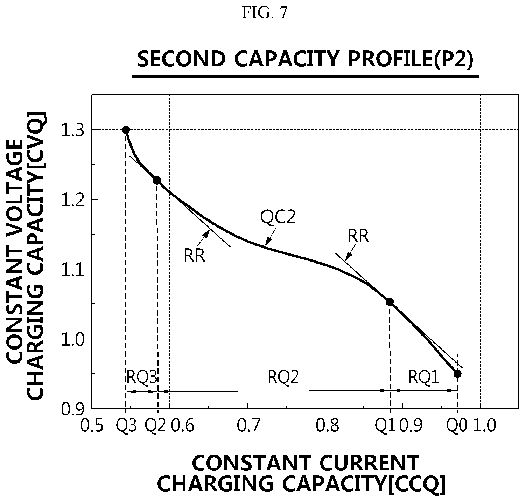

FIG. 7 is a diagram comparing a second capacity curve QC2 of the second capacity profile P2 and the reference line RR according to an embodiment of the present disclosure.

In the embodiment of FIG. 7, the second capacity curve QC2 may be a capacity curve obtained from second capacity profile P2 using a curve fitting algorithm. The second capacity curve QC2 may represent the corresponding relationship between the constant current charging capacity and the constant voltage charging capacity in the constant current charging capacity section of Q0 to Q3.

Specifically, the control unit 120 may be configured to calculate the capacity change rate for each of a plurality of constant current charging capacities included in the capacity profile. Additionally, the control unit 120 may determine a target capacity among the plurality of constant current charging capacities whose corresponding capacity change rate is the same as the reference value.

For example, in the embodiment of FIG. 7, the reference line RR with the slope of the reference value may be encountered at the Q1 point and the Q2 point in the second capacity curve QC2. That is, at the point where the constant current charging capacity is Q1 and Q2, the capacity change rate of the second capacity curve QC2 may be the same as the reference value. Therefore, the control unit 120 may determine Q1 and Q2 as a target capacity.

The control unit 120 may be configured to classify the capacity section based on the determined target capacity.

For example, in the embodiment of FIG. 7, the control unit 120 may classify Q0 to Q1 as the first capacity section RQ1, Q1 to Q2 as the second capacity section RQ2, and Q2 to Q3 as the third capacity section RQ3.

The control unit 120 may be configured to diagnose the state of the battery for the classified capacity section.

Specifically, the control unit 120 may diagnose the state of the battery for each classified capacity section. The control unit 120 may diagnose not only the current state of the battery but also the past state based on the capacity profile. That is, the control unit 120 may determine the state change pattern of the battery by diagnosing the state of the battery for each capacity section.

For example, in the embodiment of FIG. 7, the capacity change rate of the first capacity section RQ1 may exceed the reference value. Accordingly, the control unit 120 may diagnose the state of the battery in the first capacity section RQ1 as a positive electrode capacity deterioration state.

Next, the capacity change rate of the second capacity section RQ2 may be less than the reference value. Accordingly, the control unit 120 may diagnose the state of the battery in the second capacity section RQ2 as an available lithium loss state.

Finally, the capacity change rate of the third capacity section RQ3 may exceed the reference value. Accordingly, the control unit 120 may diagnose the state of the battery in the third capacity section RQ3 as a positive electrode capacity deterioration state. That is, the control unit 120 may diagnose the current state of the battery as a capacity deterioration state.

The apparatus 100 for diagnosing a battery according to an embodiment of the present disclosure has the advantage of being able to determine the state change pattern of the life cycle of the battery by specifically diagnosing the state of the battery for each capacity section. In particular, the apparatus 100 for diagnosing a battery has the advantage of being able to more efficiently collect related information that affects the change in state of the battery because it may specify the point in time when the state of the battery changes.

Meanwhile, when the state of the battery is sequentially diagnosed as a positive electrode capacity deterioration state, an available lithium loss state, and a positive electrode capacity deterioration state, the control unit 120 may be configured to diagnose the state of the battery as an unusable state.

Specifically, when the state of the battery is sequentially changed to a positive electrode capacity deterioration state, an available lithium loss state, and a positive electrode capacity deterioration state, the control unit 120 may diagnose the state of the battery as an unusable state (EOL state, End of life state). Generally, the unusable state refers to a state in which the SOH (state of health) of the battery is less than 70%, and may be a state in which disposal of the battery is recommended. If the battery in an unusable state is used continuously, there is a problem that unexpected accidents such as explosion and fire may occur.

Therefore, the apparatus 100 for diagnosing a battery has the advantage of being able to prevent unexpected accidents in advance by diagnosing the state of the battery as an unusable state when the change in state of the battery shows a certain pattern.

The control unit 120 may be configured to change a use condition preset for the battery to correspond to the state of the battery.

If the state of the battery is diagnosed as an available lithium loss state, the control unit 120 may change at least one of the upper limit of the charging C-rate preset for the battery and the rest period.

In one embodiment, the control unit 120 may reduce the upper limit of the preset charging C-rate to prevent or delay the lithium plating phenomenon in which lithium metal is precipitated on the negative electrode of the battery. For example, the control unit 120 may prevent high-rate charging of the battery by reducing the upper limit of the charging C-rate of the battery.

In one embodiment, the control unit 120 may increase the rest time set for the battery. In other words, by increasing the rest time during which the battery is maintained in an unloaded state after charging or discharging of the battery is completed, the battery may be allowed to remain in the electrical equilibrium state for a long time.

When the state of the battery is diagnosed as a positive electrode capacity deterioration state, the control unit 120 may change at least one of the upper limit voltage and the maximum allowable temperature preset for the battery.

In one embodiment, the control unit 120 may reduce the upper limit voltage and/or the maximum allowable temperature set in the battery to prevent or delay capacity deterioration of the positive electrode.

The apparatus 100 for diagnosing a battery according to an embodiment of the present disclosure has the advantage of preventing rapid deterioration of the battery by appropriately changing the use condition according to the state of the diagnosed battery.

In particular, because the apparatus 100 for diagnosing a battery may specify the point in time when the state of the battery changes, the use condition may be quickly changed to be most appropriate for the current state of the battery. Therefore, according to the apparatus 100 for diagnosing a battery, the life expectancy of the battery may be increased.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

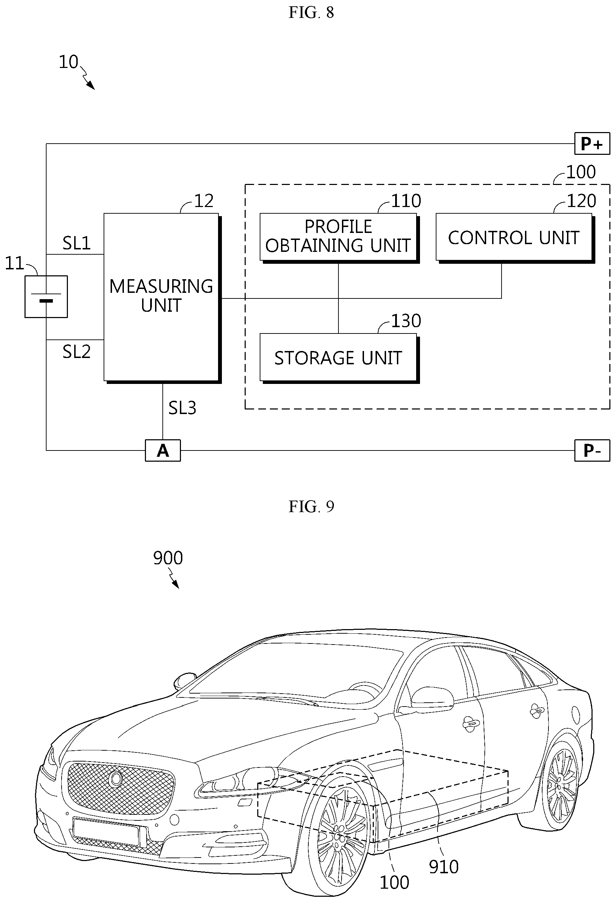

FIG. 8 is a diagram schematically showing an exemplary configuration of a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measurement unit A through the third sensing line SL3. For example, the current measurement unit A may be a current meter or shunt resistor that may measure the charging current and discharging current of the battery 11. The measuring unit 12 may calculate the charging capacity by measuring the charging current of the battery 11 through the third sensing line SL3. Additionally, the measuring unit 12 may calculate the discharge capacity by measuring the discharging current of the battery 11 through the third sensing line SL3.

An external device (not shown) may be connected to the positive electrode terminal P+ and the negative electrode terminal P- of the battery pack 10. For example, the external device may be a charging/discharging device or a motor of an electric vehicle that receives power from the battery 11. While the charging and discharging device is connected to the battery pack 10 and the battery 11 is being charged, the measuring unit 12 may measure the constant current charging capacity and the constant voltage charging capacity of the battery 11.

FIG. 9 is a diagram schematically showing an electric vehicle 900 according to still another embodiment of the present disclosure.

Referring to FIG. 9, the battery pack 910 according to an embodiment of the present disclosure may be included in a vehicle 900 such as an electric vehicle (EV) or a hybrid vehicle (HV). Additionally, the battery pack 910 may drive the vehicle 900 by supplying power to the motor through an inverter provided in the vehicle 900.

Also, the electric vehicle 900 may include the apparatus 100 for diagnosing a battery. For example, the apparatus 100 for diagnosing a battery is provided in the battery pack 910 and may diagnose the state of the battery pack 910 and/or each battery cell included in the battery pack 910.

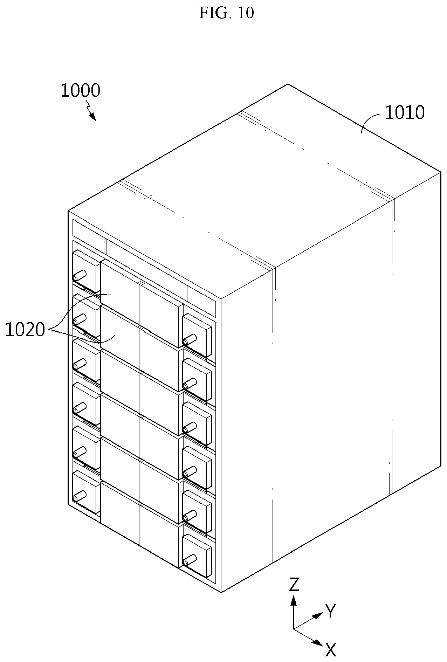

FIG. 10 is a diagram schematically showing an ESS (Energy storage system) according to still another embodiment of the present disclosure.

Referring to FIG. 10, the ESS includes a plurality of rack cases 1010 and a plurality of battery modules 1020. The plurality of battery modules 1020 may be configured to be accommodated in the rack case 1010 in a vertically arranged form.

Each of the plurality of battery modules 1020 may include the apparatus 100 for diagnosing a battery. The apparatus 100 for diagnosing a battery may diagnose the state of a corresponding battery module 1020 and/or a battery cell included in the battery module 1020.

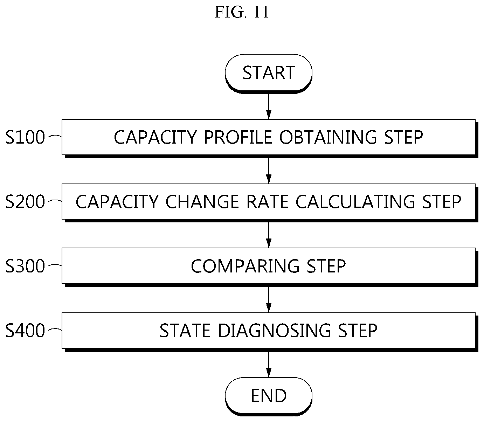

FIG. 11 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

Referring to FIG. 11, the method for diagnosing a battery may include a capacity profile obtaining step (S100), a capacity change rate calculating step (S200), a comparing step (S300), and a state diagnosing step (S400).

The capacity profile obtaining step (S100) is a step of obtaining a capacity profile for a constant current charging capacity and a constant voltage charging capacity measured in a charging process of a battery, and may be performed by the profile obtaining unit 110.

For example, the profile obtaining unit 110 may obtain a capacity profile from the outside or the storage unit 130.

The capacity change rate calculating step (S200) is a step of calculating a capacity change rate between the constant current charging capacity and the constant voltage charging capacity in the capacity profile, and may be performed by the control unit 120.

For example, the control unit 120 may calculate the capacity change rate by calculating the ratio of the constant voltage charging capacity to the constant current charging capacity.

The comparing step (S300) is a step of comparing the calculated capacity change rate and a preset reference value, and may be performed by the control unit 120.

For example, the control unit 120 may compare the magnitudes of the calculated capacity change rate and the preset reference value.

The state diagnosing step (S400) is a step of diagnosing the state of the battery based on the comparison result, and may be performed by the control unit 120.

For example, if the capacity change rate is less than the reference value, the control unit 120 may diagnose the state of the battery as an available lithium loss state. As another example, if the capacity change rate is equal to the reference value, the control unit 120 may diagnose the state of the battery as a normal state. As another example, if the capacity change rate exceeds the reference value, the control unit 120 may diagnose the state of the battery as a positive electrode capacity deterioration state.

Meanwhile, the control unit 120 may classify the capacity profile into a plurality of capacity sections and specifically diagnose the state of the battery in each capacity section. Furthermore, the control unit 120 may diagnose the state of the battery as an unusable state when the state change of the battery shows a certain pattern (in which a positive electrode capacity deterioration state, an available lithium loss state, and a positive electrode capacity deterioration state are sequentially diagnosed).

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description, since the scope of protection of the present invention is only limited by the appended claims.

### (Explanation of reference signs)

10: battery pack
11: battery
12: measuring unit
100: apparatus for diagnosing a battery
110: profile obtaining unit
120: control unit
130: storage unit
900: electric vehicle
910: battery pack
1000: ESS
1010: battery rack
1020: battery module

## Claims

1. An apparatus (100) for diagnosing a battery (11), comprising:
a profile obtaining unit (110) configured to obtain a capacity profile for a constant current charging capacity and a constant voltage charging capacity measured in a charging process of a battery (11); and
a control unit (120) configured to calculate a capacity change rate between the constant current charging capacity and the constant voltage capacity charging in the capacity profile, compare the calculated capacity change rate with a preset reference value, and diagnose the state of the battery (11) based on the comparison result,
wherein the control unit (120) is configured to diagnose the state of the battery (11) as an available lithium loss state, a normal state, or a positive electrode capacity deterioration state based on the comparison result.

2. The apparatus (100) for diagnosing a battery according to claim 1,
wherein the control unit (120) is configured to:
diagnose the state of the battery (11) as the available lithium loss state, when the capacity change rate is less than the reference value,
diagnose the state of the battery (11) as the normal state, when the capacity change rate is identical to the reference value, and
diagnose the state of the battery (11) as the positive electrode capacity deterioration state, when the capacity change rate exceeds the reference value.

3. The apparatus (100) for diagnosing a battery according to claim 1,
wherein the control unit (120) is configured to classify the capacity profile into at least one capacity section according to the magnitude relationship between the capacity change rate and the reference value, and diagnose the state of the battery (11) for the classified capacity section.

4. The apparatus (100) for diagnosing a battery according to claim 3,
wherein the control unit (120) is configured to calculate the capacity change rate for each of a plurality of constant current charging capacities included in the capacity profile, determine a target capacity whose corresponding capacity change rate is equal to the reference value among the plurality of constant current charging capacities, and classify the capacity section based on the determined target capacity.

5. The apparatus (100) for diagnosing a battery according to claim 3,
wherein the control unit (120) is configured to diagnose the state of the battery (11) as an unusable state, when the state of the battery (11) is sequentially diagnosed as the positive electrode capacity deterioration state, the available lithium loss state, and the positive electrode capacity deterioration state.

6. The apparatus (100) for diagnosing a battery according to claim 1,
wherein the control unit (120) is configured to change a use condition preset for the battery (11) to correspond to the state of the battery (11).

7. The apparatus (100) for diagnosing a battery according to claim 6,
wherein the control unit (120) is configured to:
change at least one of an upper limit of a charging C-rate preset for the battery (11) and a rest period, when the state of the battery (11) is diagnosed as the available lithium loss state, and
change at least one of an upper limit voltage and a maximum allowable temperature preset for the battery (11), when the state of the battery (11) is diagnosed as the positive electrode capacity deterioration state.

8. The apparatus (100) for diagnosing a battery according to claim 1,
wherein the capacity profile is a profile configured to accumulate and store the corresponding relationship between the constant current charging capacity and the constant voltage charging capacity measured at each charging cycle for the battery (11).

9. A battery pack (910), comprising the apparatus (100) for diagnosing a battery according to any one of claims 1 to 8.

10. A method for diagnosing a battery, comprising:
a capacity profile obtaining step of obtaining a capacity profile for a constant current charging capacity and a constant voltage charging capacity measured in a charging process of a battery (11);
a capacity change rate calculating step of calculating a capacity change rate between the constant current charging capacity and the constant voltage capacity charging in the capacity profile;
a comparing step of comparing the calculated capacity change rate with a preset reference value; and
a state diagnosing step of diagnosing the state of the battery (11) as an available lithium loss state, a normal state, or a positive electrode capacity deterioration state based on the comparison result.

## Patentansprüche

1. Vorrichtung (100) zum Diagnostizieren einer Batterie (11), die Vorrichtung aufweisend:
eine Profilerhaltungseinheit (110), die konfiguriert ist, ein Kapazitätsprofil für eine Konstantstromladekapazität und eine Konstantspannungsladekapazität, die in einem Ladeprozess einer Batterie (11) gemessen werden, zu erhalten; und
eine Steuereinheit (120), die konfiguriert ist, eine Kapazitätsänderungsrate zwischen der Konstantstromladekapazität und der Konstantspannungsladekapazität in dem Kapazitätsprofil zu berechnen, die berechnete Kapazitätsänderungsrate mit einem voreingestellten Referenzwert zu vergleichen und den Zustand der Batterie (11) basierend auf dem Vergleichsergebnis zu diagnostizieren,
wobei die Steuereinheit (120) konfiguriert ist, den Zustand der Batterie (11) als einen Zustand des Verlusts des verfügbaren Lithiums, einen Normalzustand oder einen Verschlechterungszustand der positiven Elektrodenkapazität basierend auf dem Vergleichsergebnis zu diagnostizieren.

2. Vorrichtung (100) zum Diagnostizieren einer Batterie nach Anspruch 1,
wobei die Steuereinheit (120) konfiguriert ist:
den Zustand der Batterie (11) als den Zustand des Verlusts des verfügbaren Lithiums zu diagnostizieren, wenn die Kapazitätsänderungsrate kleiner als der Referenzwert ist,
den Zustand der Batterie (11) als den Normalzustand zu diagnostizieren, wenn die Kapazitätsänderungsrate mit dem Referenzwert identisch ist, und
den Zustand der Batterie (11) als den Verschlechterungszustand der positiven Elektrodenkapazität zu diagnostizieren, wenn die Kapazitätsänderungsrate den Referenzwert überschreitet.

3. Vorrichtung (100) zum Diagnostizieren einer Batterie nach Anspruch 1,
wobei die Steuereinheit (120) konfiguriert ist, das Kapazitätsprofil in mindestens einen Kapazitätsabschnitt gemäß der Größenbeziehung zwischen der Kapazitätsänderungsrate und dem Referenzwert zu klassifizieren und den Zustand der Batterie (11) für den klassifizierten Kapazitätsabschnitt zu diagnostizieren.

4. Vorrichtung (100) zum Diagnostizieren einer Batterie nach Anspruch 3,
wobei die Steuereinheit (120) konfiguriert ist, die Kapazitätsänderungsrate für jede von mehreren Konstantstromladekapazitäten, die in dem Kapazitätsprofil enthalten sind, zu berechnen, eine Zielkapazität, deren entsprechende Kapazitätsänderungsrate gleich dem Referenzwert ist, aus den mehreren Konstantstromladekapazitäten zu bestimmen und den Kapazitätsabschnitt basierend auf der bestimmten Zielkapazität zu klassifizieren.

5. Vorrichtung (100) zum Diagnostizieren einer Batterie nach Anspruch 3,
wobei die Steuereinheit (120) konfiguriert ist, den Zustand der Batterie (11) als einen unbrauchbaren Zustand zu diagnostizieren, wenn der Zustand der Batterie (11) nacheinander als der Verschlechterungszustand der positiven Elektrodenkapazität, der Zustand des Verlusts des verfügbaren Lithiums und der Verschlechterungszustand der positiven Elektrodenkapazität diagnostiziert wird.

6. Vorrichtung (100) zum Diagnostizieren einer Batterie nach Anspruch 1,
wobei die Steuereinheit (120) konfiguriert ist, eine für die Batterie (11) voreingestellte Verwendungsbedingung zu ändern, um dem Zustand der Batterie (11) zu entsprechen.

7. Vorrichtung (100) zum Diagnostizieren einer Batterie nach Anspruch 6,
wobei die Steuereinheit (120) konfiguriert ist:
eine Obergrenze einer für die Batterie (11) voreingestellten Laderate und/oder eine Ruhezeit zu ändern, wenn der Zustand der Batterie (11) als der Zustand des Verlusts des verfügbaren Lithiums diagnostiziert wird, und
eine Obergrenzenspannung und/oder eine für die Batterie (11) voreingestellte maximal zulässige Temperatur zu ändern, wenn der Zustand der Batterie (11) als der Verschlechterungszustand der positiven Elektrodenkapazität diagnostiziert wird.

8. Vorrichtung (100) zum Diagnostizieren einer Batterie nach Anspruch 1,
wobei das Kapazitätsprofil ein Profil ist, das konfiguriert ist, die entsprechende Beziehung zwischen der Konstantstromladekapazität und der Konstantspannungsladekapazität, die in jedem Ladezyklus für die Batterie (11) gemessen werden, zu akkumulieren und zu speichern.

9. Batteriepack (910), der die Vorrichtung (100) zum Diagnostizieren einer Batterie nach einem der Ansprüche 1 bis 8 aufweist.

10. Verfahren zum Diagnostizieren einer Batterie, das Verfahren aufweisend:
einen Kapazitätsprofilerhaltungsschritt des Erhaltens eines Kapazitätsprofils für eine Konstantstromladekapazität und eine Konstantspannungsladekapazität, die in einem Ladeprozess einer Batterie (11) gemessen werden;
einen Kapazitätsänderungsratenberechnungsschritt des Berechnens einer Kapazitätsänderungsrate zwischen der Konstantstromladekapazität und der Konstantspannungsladekapazität in dem Kapazitätsprofil;
einen Vergleichsschritt des Vergleichens der berechneten Kapazitätsänderungsrate mit einem voreingestellten Referenzwert; und
einen Zustandsdiagnoseschritt des Diagnostizierens des Zustands der Batterie (11) als einen Zustand des Verlusts des verfügbaren Lithiums, einen Normalzustand oder einen Verschlechterungszustand der positiven Elektrodenkapazität basierend auf dem Vergleichsergebnis.

## Revendications

1. Appareil (100) de diagnostic d'une batterie (11), comprenant :
un dispositif d'obtention de profil (110) configuré pour obtenir un profil de capacité pour une capacité de charge à courant constant et une capacité de charge à tension constante mesurées au cours d'un processus de charge d'une batterie (11) ; et
un module de commande (120) configuré pour calculer un taux de variation de la capacité entre la capacité de charge à courant constant et la capacité de charge à tension constante dans le profil de capacité, comparer le taux de variation de la capacité calculé avec une valeur de référence préétablie, et diagnostiquer l'état de la batterie (11) en fonction du résultat de la comparaison,
le module de commande (120) étant configuré pour diagnostiquer l'état de la batterie (11) sur le plan d'un état de perte de lithium disponible, d'un état normal, ou d'un état de détérioration de la capacité de l'électrode positive, d'après le résultat de la comparaison.

2. Appareil (100) de diagnostic d'une batterie selon la revendication 1,
le module de commande (120) étant configuré pour :
diagnostiquer l'état de la batterie (11) sur le plan de l'état de perte de lithium disponible, lorsque le taux de variation de la capacité calculé est inférieur à la valeur de référence,
diagnostiquer l'état de la batterie (11) sur le plan de l'état normal, lorsque le taux de variation de la capacité calculé est identique à la valeur de référence, et
diagnostiquer l'état de la batterie (11) sur le plan de l'état de détérioration de la capacité de l'électrode positive, lorsque le taux de variation de la capacité calculé est supérieur à la valeur de référence.

3. Appareil (100) de diagnostic d'une batterie selon la revendication 1,
le module de commande (120) étant configuré pour classer le profil de capacité dans au moins une section de capacité selon la relation d'amplitude entre le taux de variation de la capacité et la valeur de référence, et diagnostiquer l'état de la batterie (11) pour la section sur la capacité classée.

4. Appareil (100) de diagnostic d'une batterie selon la revendication 3,
le module de commande (120) étant configuré pour calculer le taux de variation de la capacité pour chacune de la pluralité de capacités de charge à courant constant comprises dans le profil de capacité, déterminer une capacité cible dont le taux de variation de la capacité correspondant est égal à la valeur de référence parmi la pluralité de capacités de charge à courant constant, et classer la section de capacité en fonction de la capacité cible déterminée.

5. Appareil (100) de diagnostic d'une batterie selon la revendication 3,
le module de commande (120) étant configuré pour diagnostiquer l'état de la batterie (11) comme un état inutilisable, lorsque l'état de la batterie (11) est diagnostiqué en séquence comme l'état de détérioration de la capacité de l'électrode positive, l'état d'une perte de lithium disponible, et l'état de détérioration de la capacité de l'électrode positive.

6. Appareil (100) de diagnostic d'une batterie selon la revendication 1,
le module de commande (120) étant configuré pour modifier une condition d'utilisation préétablie pour la batterie (11) afin qu'elle corresponde à l'état de la batterie (11).

7. Appareil (100) de diagnostic d'une batterie selon la revendication 6,
le module de commande (120) étant configuré pour :
modifier au moins une d'une limite supérieure du taux C de charge préétabli pour la batterie (11) et une période de repos, lorsque l'état de la batterie (11) est diagnostiqué comme étant l'état d'une perte de lithium disponible, et
modifier au moins une d'une tension limite supérieure et d'une température admissible maximum préétablie pour la batterie (11), lorsque l'état de la batterie (11) est diagnostiqué comme étant un état de détérioration de la capacité de l'électrode positive.

8. Appareil (100) de diagnostic d'une batterie selon la revendication 1,
le profil de capacité étant un profil configuré pour accumuler et stocker le rapport correspondant entre la capacité de charge de courant constant et la capacité de charge de tension constante mesurées à chaque cycle de charge pour la batterie (11).

9. Bloc-batterie (910) comprenant l'appareil (100) pour le diagnostic d'une batterie selon une quelconque des revendications 1 à 8.

10. Procédé de diagnostic d'une batterie comprenant :
une étape d'obtention d'un profil de capacité comportant l'obtention d'un profil de capacité pour une capacité de charge à courant constant et une capacité de charge à tension constante mesurées au cours d'un processus de charge d'une batterie (11) ;
une étape de calcul d'un taux de variation de la capacité, comportant le calcul d'un taux de variation de la capacité entre la capacité de charge à courant constant et la capacité de charge à tension constante dans le profil de capacité ;
une étape de comparaison comportant la comparaison du taux de variation de la capacité calculé avec une valeur de référence préétablie ; et
une étape de diagnostic comportant le diagnostic de l'état de la batterie (11) en tant qu'un état de perte de lithium disponible, un état normal, ou un état de détérioration de la capacité de l'électrode positive, d'après le résultat de la comparaison.
